# EUROPEAN PATENT APPLICATION

(11) **EP 4 697 683 A1**
(43) Date of publication of application: **18.02.2026**
(21) Application number: 24787987.7
(22) Date of filing: 07.04.2024
(51) Int. Cl.: H04M 1/02, G06F 1/16, G09F 9/30

(54) **ELECTRONIC DEVICE**

(30) Priority: 13.04.2023 CN 202310403572
(71) Applicant: Vivo Mobile Communication Co., Ltd., Dongguan, Guangdong 523863 (CN)
(72) Inventor: JI, Guisheng, Dongguan, Guangdong 523863 (CN)
(74) Representative: Lavoix
(86) International application number: PCT/CN2024/086320
(87) International publication number: WO 2024/212884

(57) **Abstract**

This application discloses an electronic device, and relates to the field of electronic devices. The electronic device includes a base, a first support, a first connecting arm, and an extruded member, where the first support is configured to support a screen of the electronic device, a first end of the first connecting arm is rotatably mounted on the first support, a second end of the first connecting arm is provided with a first arc-shaped fitting structure, the first arc-shaped fitting structure is rotatably fitted with the base, to enable the electronic device to switch between a folded state and an unfolded state, and the extruded member is disposed between the first support and the first connecting arm; when the electronic device is in the folded state, the extruded member abuts between the first arc-shaped fitting structure and the first support; and when the electronic device is in the unfolded state, either of the first support and the first arc-shaped fitting structure is separated from the extruded member.

## Description

### CROSS-REFERENCE TO RELATED APPLICATIONS

This application claims priority to Chinese Patent Application No. 202310403572.3, filed with the China National Intellectual Property Administration on April 13, 2023 and entitled "ELECTRONIC DEVICE", which is incorporated herein by reference in its entirety.

### TECHNICAL FIELD

This application relates to the technical field of electronic devices, and specifically, to an electronic device.

### BACKGROUND

With the progress of technologies, a user has an increasingly strong requirement on a foldable electronic device with both a large display area and strong portability. Generally, a hinge mechanism is disposed in the foldable electronic device, and supports configured to support a screen in the electronic device are connected to each other through the hinge mechanism. To ensure that the two supports have capabilities of rotating relative to each other, an assembly gap needs to be provided between components that are in the hinge mechanism and that are configured to provide rotation functions. However, affected by the assembly gap between the components in the hinge mechanism, axial rubbing easily occurs between the two supports of the electronic device, especially when the electronic device is in a folded state. This may cause a great adverse effect on a service life of the electronic device.

### SUMMARY

Embodiments of this application provide an electronic device, to resolve a problem that axial rubbing occurs when the electronic device is in a folded state, thereby extending a service life of the electronic device.

An embodiment of this application provides an electronic device, including a base, a first support, a first connecting arm, and an extruded member, where the first support is configured to support a screen of the electronic device, a first end of the first connecting arm is rotatably mounted on the first support, a second end of the first connecting arm is provided with a first arc-shaped fitting structure, the first arc-shaped fitting structure is rotatably fitted with the base, to enable the electronic device to switch between a folded state and an unfolded state, and the extruded member is disposed between the first support and the first connecting arm; when the electronic device is in the folded state, the extruded member abuts between the first arc-shaped fitting structure and the first support; and when the electronic device is in the unfolded state, either of the first support and the first arc-shaped fitting structure is separated from the extruded member.

An embodiment of this application discloses an electronic device. In the electronic device, a first support is configured to support a screen of the electronic device. A first end of the first connecting arm is rotatably mounted on the first support, and a second end of the first connecting arm is provided with a first arc-shaped fitting structure. The first arc-shaped fitting structure is rotatably fitted with the base, so that a rotation fit relationship can be formed between the first connecting arm and the base, and the first arc-shaped fitting structure can be used to limit a movement track of the first connecting arm.

As described above, the first support is rotatably connected to the base through the first connecting arm, so that the electronic device can switch between a folded state and an unfolded state. An extruded member is disposed between the first support and the first connecting arm. When the electronic device is in the folded state, the extruded member abuts between the first arc-shaped fitting structure and the first support, so that the first arc-shaped fitting structure and the base can be extruded and fitted in a direction perpendicular to a rotating axial direction of the first connecting arm by using the extruded member, and further a static friction is generated between the first arc-shaped fitting structure and the base, to prevent relative movement between the first arc-shaped fitting structure and the base along the rotating axial direction of the first connecting arm when no external force is applied. In other words, when the electronic device is in the folded state, relative rubbing can be prevented between the first support and the base in the rotating axial direction of the first connecting arm, thereby extending a service life of the electronic device and improving user experience.

In addition, when the electronic device is in the unfolded state, either of the first support and the first arc-shaped fitting structure can be separated from the extruded member, so that a gap fit relationship is formed between the first arc-shaped fitting structure and the base in the direction perpendicular to the rotating axial direction of the first connecting arm, to reduce difficulty when the first arc-shaped fitting structure and the base rotate relative to each other, and improve smoothness when the first support and the base rotate relative to each other.

### BRIEF DESCRIPTION OF DRAWINGS

FIG. 1 is a schematic cross-sectional view of a partial structure of an electronic device according to an embodiment of this application;
FIG. 2 is a schematic diagram of assembly of an extruded member and a first connecting arm in an electronic device according to an embodiment of this application;
FIG. 3 is a schematic diagram of assembly of an extruded member and a first support in an electronic device according to an embodiment of this application;
FIG. 4 is a schematic diagram of one assembly manner of an extruded member in an electronic device according to an embodiment of this application;
FIG. 5 is a schematic diagram of an electronic device in a folded state according to an embodiment of this application;
FIG. 6 is a schematic diagram of an electronic device in an unfolded state according to an embodiment of this application; and
FIG. 7 is a schematic diagram of another structure of an electronic device according to an embodiment of this application.

### Reference numerals:

100-Base, 110-second arc-shaped fitting structure, 111-arc-shaped protrusion, 120-fourth arc-shaped fitting structure,
210-first support, 211-cavity opening, 220-second support, 230-limiting plate,
310-first connecting arm, 311-first arc-shaped fitting structure, 311a-arc-shaped sliding groove, 320-second connecting arm, 321-third arc-shaped fitting structure,
400-extruded member, 410-body, 420-first protruding edge, and 430-second protruding edge

### DETAILED DESCRIPTION

The following clearly describes technical solutions in embodiments of this application with reference to the accompanying drawings in the embodiments of this application. Apparently, the described embodiments are some of the embodiments of this application rather than all of the embodiments. All other embodiments obtained by a person of ordinary skill in the art based on the embodiments of this application shall fall within the protection scope of the application.

The specification and claims of this application, and terms "first" and "second" are used to distinguish similar objects, but are unnecessarily used to describe a specific sequence or order. It should be understood that the data used in such a way is interchangeable in proper circumstances, so that the embodiments of this application described herein can be implemented in other sequences than the sequence illustrated or described herein, and terms "first" and "second" are used to distinguish similar objects, but are unnecessarily used to describe a specific sequence or order, for example, a first object may be one or more. In addition, "and/or" in this specification and the claims represents at least one of the connected objects, and the character "/" represents that the related objects before and after the character "/" are in an "or" relationship.

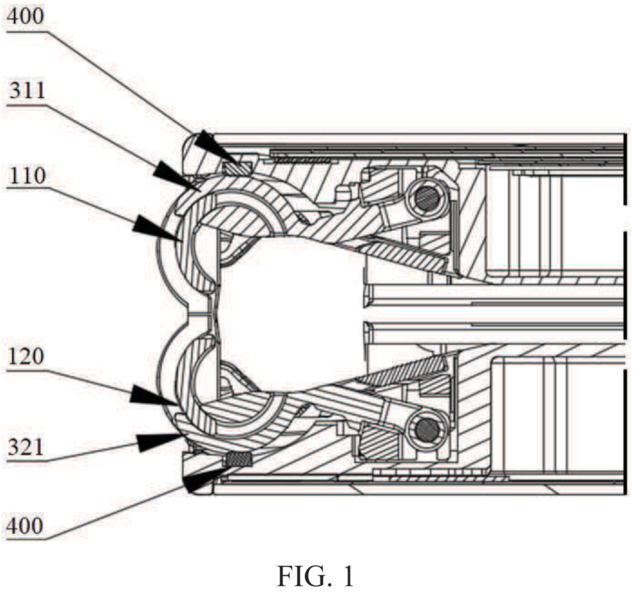

As shown in FIG. 1 to FIG. 7, embodiments of this application provide an electronic device. The electronic device may be a foldable electronic device, and includes a base 100, a first support 210, a first connecting arm 310, and an extruded member 400. Certainly, the electronic device may further include components such as a screen, a camera, and a battery. Considering conciseness of the text, details are not described herein.

In the electronic device, the base 100 is a mounting base for other components. The base 100 may be formed by using hard materials such as metal or plastic. A shape and construction of the base 100 may be determined according to specific conditions. The first support 210 is configured to support a screen of the electronic device. The first support 210 may be a plate-shaped structural member, to provide a mounting function for the screen.

The first connecting arm 310 is a component for connecting the base 100 and the first support 210. Optionally, a first end of the first connecting arm 310 is rotatably mounted on the first support 210 through structural members such as a rotating shaft, so that a rotation fit relationship is formed between the first connecting arm 310 and the first support 210. In addition, a second end of the first connecting arm 310 is provided with a first arc-shaped fitting structure 311, and the first connecting arm 310 is rotatably fitted with the base 100 through the first arc-shaped fitting structure 311, so that the electronic device can switch between a folded state and an unfolded state.

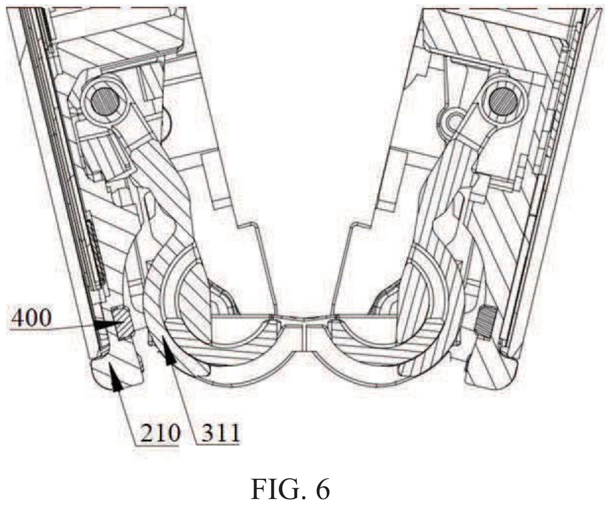

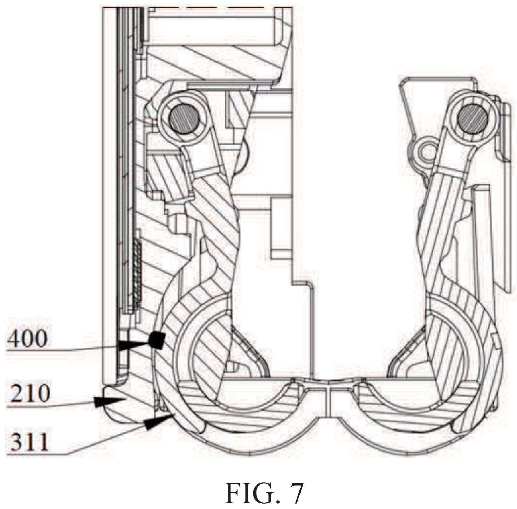

A shape of the first arc-shaped fitting structure 311 may be determined according to an actual requirement, to limit a movement track of the first connecting arm 310 by using a parameter design of the first arc-shaped fitting structure 311, so that a distance between the first end of the first connecting arm 310 and the first support 210 can be changed in a process in which the first connecting arm 310 rotates relative to the base 100. In this way, a distance between the second end of the first connecting arm 310 and the first support 210 can be changed in a process in which the electronic device switches between the folded state and the unfolded state, to change a fitting state (as shown in FIG. 6 and FIG. 7) between the extruded member 400 and the first base 210 and the first connecting arm 310.

The extruded member 400 may be made of a material having a specific elastic capability, such as rubber, to prevent the extruded member 400 from being brittle and damaged in a process of being extruded. In an optional embodiment of this application, the extruded member 400 is a self-lubricating structural member. In other words, the extruded member 400 may be a structural member made of a self-lubricating material, or may be an elastic structural member whose surface is coated with the self-lubricating material. The self-lubricating material is a material that reduces friction and wear between two bearing surfaces by using a solid powder, a thin film, or some integral materials. The self-lubricating material is coated on a surface of the extruded member 400, or the self-lubricating material is directly used to prepare the extruded member 400, so that fitting smoothness between the extruded member 400 and the first connecting arm 310 can be improved, to extend a service life of the extruded member 400. Optionally, the extruded member 400 may be formed by polyformaldehyde resin, or a material containing POM or modified polytetrafluorethylene.

In a process of assembling the electronic device, the extruded member 400 is disposed between the first support 210 and the first connecting arm 310, so that in a process in which the electronic device switches from the unfolded state to the folded state, the extruded member 400 can be in contact with both the first support 210 and the first connecting arm 310 after the first connecting arm 310 and the first support 210 continuously move relative to each other until a gap between the first connecting arm 310 and the first support 210 is reduced to a preset value. The extruded member 400 is configured to provide an extruding action, so that the first connecting arm 310 extrudes the base 100, to prevent the first connecting arm 310 and the base 100 from moving relative to each other in a rotating axial direction of the first connecting arm 310. In addition, due to existence of the extruded member 400, rotating damping between the first connecting arm 310 and the first support 210 can be improved, thereby achieving a small-angle hovering effect.

Correspondingly, in a process in which the electronic device switches from the folded state to the unfolded state, after the first connecting arm 310 and the first support 210 move relative to each other until the gap between the first connecting arm 310 and the first support 210 increases to a preset value, the extruded member 400 is separated from either of the first support 210 and the first connecting arm 310, to prevent the extruded member 400 from continuously providing the extruding action, thereby ensuring relative smoothness in a subsequent relative rotation process between the first connecting arm 310 and the base 100.

In terms of a specific state of the electronic device, when the electronic device is in the folded state, the extruded member 400 abuts between the first arc-shaped fitting structure 311 and the first support 210, so that the extruded member 400 is used to extrude the first arc-shaped fitting structure 311, the first arc-shaped fitting structure 311 extrudes the base 100 in a direction perpendicular to the rotating axial direction of the first connecting arm 310, and the first arc-shaped fitting structure 311 and the base 100 contact with each other in the foregoing direction, thereby generating a static friction to prevent relative movement between the first connecting arm 310 and the base 100 in the rotating axial direction of the first connecting arm 310 when no external force is applied to the electronic device.

When the electronic device is in the unfolded state, either of the first support 210 and the first arc-shaped fitting structure 311 is separated from the extruded member 400, to ensure that when the electronic device switches to the unfolded state, there is a gap fit relationship between the first arc-shaped fitting structure 311 and the base 100 in the direction perpendicular to the rotating axial direction of the first connecting arm 310, to ensure that the first arc-shaped fitting structure 311 and the base 100 have good relative movement capabilities.

It should be noted that, parameters such as a size or a shape of the extruded member 400 are designed, so that in the process in which the electronic device switches from the unfolded state to the folded state, when the first support 210 in the electronic device rotates by a preset angle such as 80° relative to the base 100, the extruded member 400 can abut between the first arc-shaped fitting structure 311 and the first support 210. As the electronic device continues to be folded, the extruded member 400 is continuously extruded, so that a gap between the first arc-shaped fitting structure 311 and the base 100 is gradually reduced until the electronic device is or is about to be in the folded state, to ensure that the first arc-shaped fitting structure 311 is in contact with the base 100 and a static friction relationship is formed.

Correspondingly, in the process in which the electronic device switches from the folded state to the unfolded state, as the first support 210 gradually rotates relative to the base 100, the extruding action performed by the extruded member 400 on the first arc-shaped fitting structure 311 is gradually reduced. After the first support 210 rotates relative to the base 100 by a preset angle such as 10°, the extruded member 400 no longer provides the extruding action for the first arc-shaped fitting structure 311. In this case, the gap fit relationship between the first arc-shaped fitting structure 311 and the base 100 is restored, to ensure that the first arc-shaped fitting structure 311 and the base 100 rotate relatively smoothly in a subsequent rotation process, until the electronic device switches to the unfolded state. Certainly, an actual value of the foregoing preset angle may be flexibly designed according to specific applications, and this is not limited in this specification.

An embodiment of this application provides an electronic device. In the electronic device, a first support 210 is configured to support a screen of the electronic device. In addition, a first end of the first connecting arm 310 is rotatably mounted on the first support 210, and a second end of the first connecting arm 310 is provided with a first arc-shaped fitting structure 311. The first arc-shaped fitting structure 311 is rotatably fitted with a base 100, so that a rotation fit relationship can be formed between the first connecting arm 310 and the base 100, and the first arc-shaped fitting structure 311 can be used to limit a movement track of the first connecting arm 310.

As described above, the first support 210 is rotatably connected to the base 100 through the first connecting arm 310, so that the electronic device can switch between a folded state and an unfolded state. An extruded member 400 is disposed between the first support 210 and the first connecting arm 310. When the electronic device is in the folded state, the extruded member 400 abuts between the first arc-shaped fitting structure 311 and the first support 210, so that the first arc-shaped fitting structure 311 can extrude and be in fit with the base 100 in a direction perpendicular to a rotating axial direction of the first connecting arm 310 by using the extruded member 400, and a static friction is generated between the first arc-shaped fitting structure 311 and the base 100, to prevent relative movement between the first arc-shaped fitting structure 311 and the base 100 from being generated along the rotating axial direction of the first connecting arm 310 when no external force is applied. In other words, when the electronic device is in the folded state, relative rubbing between the first support 210 and the base 100 in the rotating axial direction of the first connecting arm 310 can be prevented, thereby extending a service life of the electronic device.

In addition, when the electronic device is in the unfolded state, either of the first support 210 and the first arc-shaped fitting structure 311 can be separated from the extruded member 400, so that a gap fit relationship is formed between the first arc-shaped fitting structure 311 and the base 100 in the direction perpendicular to the rotating axial direction of the first connecting arm 310, to reduce difficulty when the first arc-shaped fitting structure 311 and the base 100 rotate relative to each other, and improve smoothness when the first support 210 and the base 100 rotate relative to each other.

As described above, the second end of the first connecting arm 310 is provided with the first arc-shaped fitting structure 311, and the first arc-shaped fitting structure 311 is rotatably fitted with the base 100. Optionally, the base 100 is provided with a second arc-shaped fitting structure 110. A shape of the first arc-shaped fitting structure 311 is adapted to a shape of the second arc-shaped fitting structure 110, so that it can be ensured that a stable rotation fit relationship is formed between the first arc-shaped fitting structure 311 and the second arc-shaped fitting structure 110. In addition, parameters of the first arc-shaped fitting structure 311 are designed, so that a rotating track of the first connecting arm 310 may also be limited.

Optionally, the first arc-shaped fitting structure 311 and the second arc-shaped fitting structure 110 may be shaft-hole fitting structures. For example, the first arc-shaped fitting structure 311 may be an arc-shaped column shaft structure, and the second arc-shaped fitting structure 110 may be an arc-shaped deep-hole structure. In this case, the first arc-shaped fitting structure 311 may extend into the second arc-shaped fitting structure 110, and move in the second arc-shaped fitting structure 110 in a rotating direction of the first connecting arm 310, so that the first arc-shaped fitting structure 311 is rotatably fitted with the second arc-shaped fitting structure 110.

In another embodiment of this application, one of the first arc-shaped fitting structure 311 and the second arc-shaped fitting structure 110 is provided with an arc-shaped sliding groove 311 a, and the other of the first arc-shaped fitting structure 311 and the second arc-shaped fitting structure 110 includes an arc-shaped protrusion 111. In a process in which the electronic device switches between the folded state and the unfolded state, the arc-shaped protrusion 111 is in slidable fit with the arc-shaped sliding groove 311 a. Optionally, a plugging and fitting direction between the arc-shaped protrusion 111 and the arc-shaped sliding groove 311a is the rotating axial direction of the first connecting arm 310. In this way, fitting stability between the arc-shaped protrusion 111 and the arc-shaped sliding groove 311a is always relatively high. In addition, when the extruded member 400 extrudes the first arc-shaped fitting structure 311, a surface contact relationship can be formed between the first arc-shaped fitting structure 311 and the second arc-shaped fitting structure 110 through arc-shaped surfaces of the first arc-shaped fitting structure 311 and the second arc-shaped fitting structure 110, to increase an static friction effect between the first arc-shaped fitting structure 311 and the second arc-shaped fitting structure 110, and further improve reliability of a relative fixed relationship between the first connecting arm 310 and the base 100 in the electronic device when the electronic device is in the folded state.

As described above, the extruded member 400 can be extruded between the first support 210 and the first connecting arm 310, and the extruded member 400 may be further separated from either of the first support 210 and the first connecting arm 310. Based on this, the extruded member 400 may be mounted on the first support 210, or the extruded member 400 may also be mounted on the first connecting arm 310.

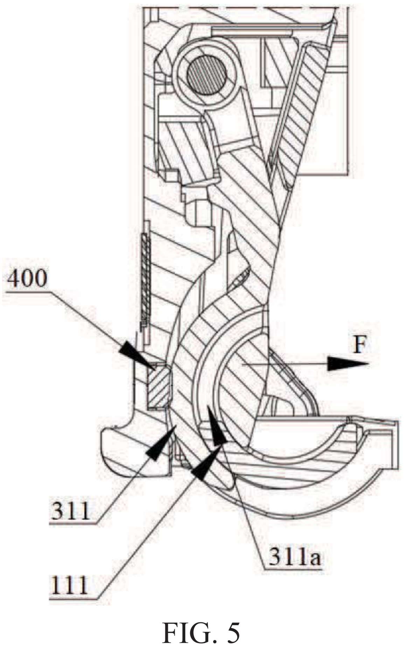

In an optional embodiment of this application, the extruded member 400 is disposed on the first support 210. When the electronic device is in a folded state, a first arc-shaped fitting structure 311 can extrude the extruded member 400. Correspondingly, the extruded member 400 can also extrude the first arc-shaped fitting structure 311, so that the first arc-shaped fitting structure 311 and the base 100 extrude each other in the direction perpendicular to the rotating axial direction of the first connecting arm 310 (a force F shown in FIG. 5), to prevent the first connecting arm 310 and the base 100 from moving relative to each other along the rotating axial direction of the first connecting arm 310. In addition, when the electronic device is in the unfolded state, the first arc-shaped fitting structure 311 is separated from the extruded member 400, to ensure that the extruded member 400 no longer provides an extruding action. In addition, a gap fit relationship is formed between the first arc-shaped fitting structure 311 and the base 100, to ensure a relative smooth rotation process between the first arc-shaped fitting structure 311 and the base 100.

Optionally, the extruded member 400 may be fixed on the first support 210 in a manner such as adhesion. A mounting location of the extruded member 400 is designed, so that it can be ensured that the first connecting arm 310 can gradually approach the first support 210, in a process in which the electronic device switches to the folded state. In addition, when the electronic device is or is to be in the folded state, the extruded member 400 can abut against the first arc-shaped fitting structure 311 of the first connecting arm 310.

In another embodiment of this application, the extruded member 400 may alternatively be mounted on the first support 210 in a manner of embedding. Specifically, a groove is provided on the first support 210 at a position opposite to the first arc-shaped fitting structure 311. In a manner in which the extruded member 400 is disposed in the groove, and a part of the extruded member 400 is disposed outside the groove, the extruded member 400 can also be mounted on the first support 210. In addition, it can be ensured that the part of the extruded member 400 that is located outside the groove and the first arc-shaped fitting structure 311 can extrude each other. In addition, the parameters such as a shape and a size of the groove are designed, so that the extruded member 400 can be mounted in the groove in a manner of an interference fit, and a relative stable fitting relationship is formed between the extruded member 400 and the first support 210. For example, the extruded member 400 may be of a circle-shaped column structure, and the groove may also be in a shape of a circle-shaped counter bore. A diameter of the groove is slightly less than a diameter of the extruded member 400, so that it can be ensured that the extruded member 400 can be stably fixed in the groove.

In another embodiment of this application, an interference fit relationship may be formed between the extruded member 400 and the groove only in a direction perpendicular to both the rotating axial direction of the first connecting arm 310 and a depth direction of the groove. This can also ensure that the extruded member 400 can be stably mounted in the groove, and mounting difficulty of the extruded member 400 is relatively lower.

To further improve stability of the relative fixed relationship between the extruded member 400 and the first support 210, optionally, the groove includes a mounting cavity and limiting cavities. The mounting cavity includes a cavity opening 211, and the mounting cavity is formed by being recessed from the cavity opening 211, that is, a shape of the mounting cavity is the same as a shape of the cavity opening 211. In addition, limiting cavities are provided on two sides of the mounting cavity that face away from each other. Each limiting cavity is in communication with the mounting cavity. The limiting cavities and the extruded member 400 are mutually limited in an axial direction of the cavity opening 211 of the mounting cavity, that is, in a depth direction of the mounting cavity. Generally, the groove is a structure whose internal contour covers the cavity opening 211, and the limiting cavities thereof are spaces in which the groove is not exposed by the cavity opening 211 of the mounting cavity and is hidden below a surface of the first support 210.

Based on the foregoing structure of the groove, the extruded member 400 includes a body 410 and first protruding edges 420. The first protruding edges 420 are connected to two sides of the body 410 that face away from each other. In addition, in the rotating axial direction of the first connecting arm 310, a size of the extruded member 400 is less than a size of the cavity opening 211 of the mounting cavity, so that after the extruded member 400 is mounted into the mounting cavity from the cavity opening 211 of the mounting cavity, the extruded member 400 can be further moved in the mounting cavity along the rotating axial direction of the first connecting arm 310. Based on this, after the extruded member 400 is mounted into the mounting cavity from the cavity opening 211 of the mounting cavity, the extruded member 400 is moved along the rotating axial direction of the first connecting arm 310, so that the first protruding edges 420 connected to one side of the body 410 can extend into the limiting cavities. In this way, the extruded member 400 cannot be separated from the groove from the cavity opening 211 of the mounting cavity under limiting actions of the first protruding edges 420 and the limiting cavities along a depth direction of the mounting cavity. Therefore, reliability of a relatively fixed relationship between the extruded member 400 and the first support 210 is further improved.

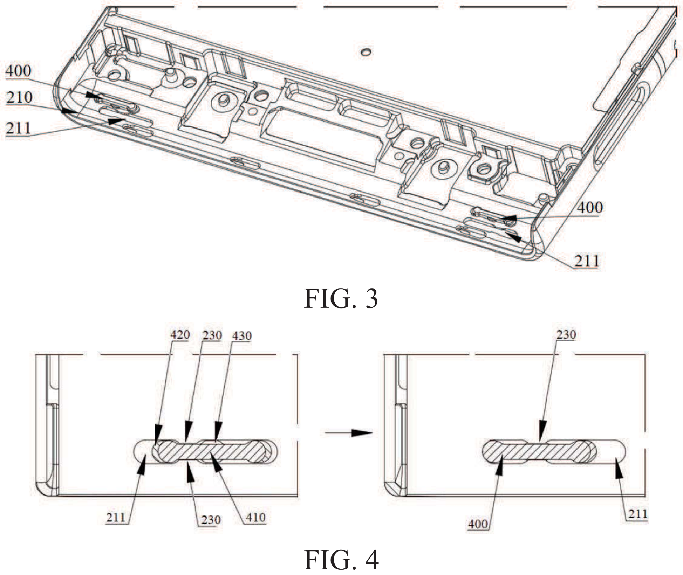

In addition, when the foregoing technical solution is used, as shown in FIG. 4, after the extruded member 400 is mounted into the mounting cavity from the cavity opening 211 of the mounting cavity, because the first protruding edges 420 are connected to the two sides of the body 410 that face away from each other, and limiting cavities are provided on the two sides of the mounting cavity that face away from each other, no matter the extruded member 400 is moved to a left side or a right side along the rotating axial direction of the first connecting arm 310, a limiting fit relationship can be formed between the first protruding edges 420 and the limiting cavities, which can reduce the mounting difficulty of the extruded member 400. Certainly, in a process of designing the first protruding edges 420 and the limiting cavities, shapes and sizes of the first protruding edges 420 and the limiting cavities are designed, so that it can be ensured that the first protruding edges 420 can extend into the limiting cavities and the first protruding edges 420 and the limiting cavity are mutually limited in the depth direction of the groove.

Optionally, the body 410 and the first protruding edges 420 of the extruded member 400 may be integrally formed, to improve connection reliability between the body 410 and the first protruding edges 420. Further, after the first protruding edges 420 cooperate with the limiting cavities, a limiting relationship between the extruded member 400 and the first support 210 is more stable. Shapes of the first protruding edges 420 may be determined according to an actual requirement, which is not limited in the embodiments of this specification.

Certainly, when the extruded member 400 includes the body 410 and the first protruding edges 420, in addition to the foregoing interference fit manner, a manner of disposing second protruding edges 430 may also be used to improve the stability of the relative fixed relationship between the extruded member 400 and the groove. As described above, the first protruding edges 420 are disposed on the two sides of the body 410 that face away from each other, and the two first protruding edges 420 are distributed along the rotating axial direction of the first connecting arm 310. Based on this, as shown in FIG. 4, in a direction in which the body 410 is perpendicular to both the rotating axial direction of the first connecting arm 310 and the depth direction of the groove, second protruding edges 430 can be disposed on the two sides of the body 410 that face away from each other, and a corresponding limiting space is disposed at a corresponding position on the body 410. The second protruding edges 430 and the foregoing limiting space are mutually limited in the depth direction of the groove, so that it can be ensured that a relatively fixed relationship is stably formed between the extruded member 400 and the groove.

Alternatively, a limiting plate 230 may be disposed at the cavity opening 211 of the mounting cavity, and the limiting plate 230 extends toward a center of the cavity opening 211 of the mounting cavity. In this way, after the extruded member 400 is mounted into the mounting cavity from the cavity opening 211 of the mounting cavity, the extruded member 400 is moved along the rotating axial direction of the first connecting arm 310. When the first protruding edges 420 extend into the limiting cavities, the second protruding edges 430 may also be moved to a position of the limiting plate 230, so that the second protruding edges 430 are clamped on the limiting plate 230 in the depth direction of the groove.

Certainly, in the foregoing embodiment, the groove may be a structure having a groove bottom, that is, the groove is of a structure similar to a shape of a blind hole, to ensure that the extruded member 400 is not separated from the groove from a side facing away from the cavity opening 211 of the mounting cavity. Alternatively, a limiting structure may also be disposed at a groove bottom of the groove, to prevent the extruded member 400 from being separated from a side facing away from the cavity opening 211 of the mounting cavity of the groove.

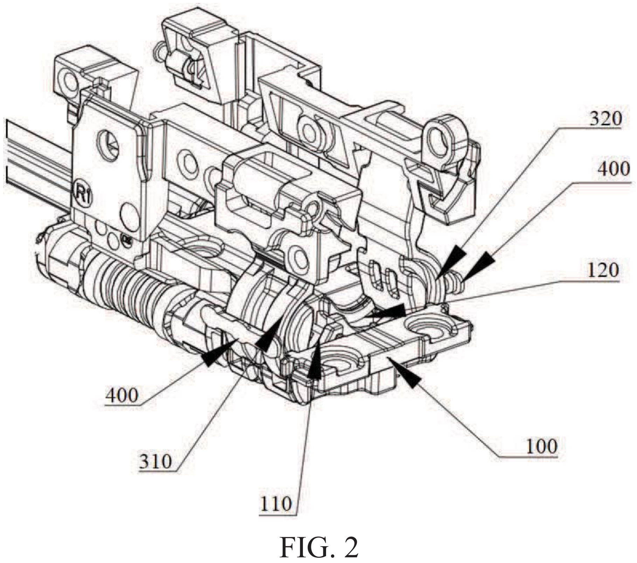

In the electronic device disclosed in the foregoing embodiments, to improve fitting stability between the extruded member 400 and the first connecting arm 310, the parameters such as a size and a mounting position of the extruded member 400 are designed. As shown in FIG. 2, in the rotating axial direction of the first connecting arm 310, two ends of the extruded member 400 that face away from each other can extend out of the first arc-shaped fitting structure 311, to ensure that the first arc-shaped fitting structure 311 can be entirely extruded by the extruded member 400, thereby improving compatibility between the first arc-shaped fitting structure 311 and the base 100 that extrude and are in fit with each other.

As described above, the extruded member 400 may be disposed on the first support 210. In another embodiment of this application, the extruded member 400 is disposed on the first arc-shaped fitting structure 311. Optionally, a fixed connecting relationship may be formed between the extruded member 400 and the first arc-shaped fitting structure 311 by means of adhesion or insert injection molding. In the embodiment, when the electronic device is in the folded state, the first support 210 extrudes the extruded member 400. Correspondingly, when the electronic device is in the unfolded state, the first support 210 is separated from the extruded member 400. Similarly, parameters such as a shape of the first arc-shaped fitting structure 311 may also be designed, to achieve an objective of controlling the movement track of the first connecting arm 310. In this way, in a process in which the electronic device switches between the folded state and the unfolded state, a distance between the first arc-shaped fitting structure 311 and the first support 210 can be changed correspondingly, the first support 210 extrudes the extruded member 400, and the first support 210 is separated from the extruded member 400.

As described above, the electronic device includes the base 100, the first support 210, and the first connecting arm 310, where the first support 210 is connected to the base 100 through the first connecting arm 310. Correspondingly, the electronic device may further include a second support 220 and a second connecting arm 320, where the second support 220 is also configured to support a screen of the electronic device. In addition, a first end of the second connecting arm 320 is rotatably mounted on the second support 220 through a connecting member such as a rotating shaft, so that a connecting relationship can be formed between the second support 220 and the second connecting arm 320. A third arc-shaped fitting structure 321 is disposed on a second end of the second connecting arm 320. The third arc-shaped fitting structure 321 is rotatably fitted with the base 100, so that a rotation fit relationship is formed between the second support 220 and the base 100.

Optionally, the base 100 may be provided with a fourth arc-shaped fitting structure 120, so that the base 100 is connected to the third arc-shaped fitting structure 321 through the fourth arc-shaped fitting structure 120, and further the second support 220 is connected to the base 100. In addition, the parameters such as a shape of the third arc-shaped fitting structure 321 is designed, so that a movement track of the second connecting arm 320 can be limited, so that in the process in which the electronic device switches between the unfolded state and the folded state, a gap between the second connecting arm 320 and the second support 220 is correspondingly reduced or enlarged, to change a fitting state between the extruded member 400 disposed between the second support 220 and the second connecting arm 320 and the second support 220 and the second connecting arm 320.

Specifically, when the electronic device is in the folded state, the extruded member 400 located between the second support 220 and the second connecting arm 320 abuts between the third arc-shaped fitting structure 321 and the second support 220. In this way, the third arc-shaped fitting structure 321 extrudes and contacts the fourth arc-shaped fitting structure 120 of the base 100 in a direction perpendicular to a rotating axial direction of the second connecting arm 320, so that the static friction is generated between the third arc-shaped fitting structure 321 and the fourth arc-shaped fitting structure 120 of the base 100, to prevent relative movement between the second connecting arm 320 and the base 100 along the rotating axial direction of the second connecting arm 320 from being generated.

Correspondingly, when the electronic device is in the unfolded state, either of the second support 220 and the third arc-shaped fitting structure 321 is separated from the extruded member 400, so that a gap fit relationship is formed between the second support 220 and the base 100 in the electronic device in the unfolded state, to ensure relatively good smoothness of relative movement between the second support 220 and the base 100.

Certainly, similar to the first support 210 and the first connecting arm 310, the parameters such as the size of the extruded member 400 are designed, after the electronic device rotates by a preset angle in the process of switching from the unfolded state to the folded state, even if both the second support 220 and the second connecting arm 320 are in contact with the extruded member 400, as the electronic device continues to rotate toward the folded state, the second support 220 and the second connecting arm 320 can continuously extrude the extruded member 400. In this way, the gap between the second connecting arm 320 and the base 100 is continuously reduced, and until the electronic device switches to or is to switch to the folded state, an extruding contact relationship is formed between the third arc-shaped fitting structure 321 of the second connecting arm 320 and the base 100, to prevent the relative movement between the second connecting arm 320 and the base 100 along a rotating axial direction of the second connecting arm 320 from being generated. Correspondingly, in a process in which the electronic device switches from the folded state to the unfolded state, as the second support 220 rotates relative to the base 100, an extruding effect of the extruded member 400 on the second support 220 and the second connecting arm 320 is gradually reduced. After the second support 220 rotates by a preset angle relative to the base 100, either of the second support 220 and the second connecting arm 320 may be separated from the extruded member 400, to ensure relatively good smoothness of the second connecting arm 320 in a subsequent rotation process.

The embodiments of this application have been described above with reference to the accompanying drawings. This application is not limited to the specific implementations described above, and the specific implementations described above are merely exemplary and not limitative. A person of ordinary skill in the art may make various variations under the teaching of this application without departing from the spirit of this application and the protection scope of the claims, and such variations shall all fall within the protection scope of this application.

## Claims

1. An electronic device, comprising a base, a first support, a first connecting arm, and an extruded member, wherein the first support is configured to support a screen of the electronic device, a first end of the first connecting arm is rotatably mounted on the first support, a second end of the first connecting arm is provided with a first arc-shaped fitting structure, the first arc-shaped fitting structure is rotatably fitted with the base, to enable the electronic device to switch between a folded state and an unfolded state, and the extruded member is disposed between the first support and the first connecting arm;
when the electronic device is in the folded state, the extruded member abuts between the first arc-shaped fitting structure and the first support; and
when the electronic device is in the unfolded state, either of the first support and the first arc-shaped fitting structure is separated from the extruded member.

2. The electronic device according to claim 1, wherein the base is provided with a second arc-shaped fitting structure, one of the first arc-shaped fitting structure and the second arc-shaped fitting structure is provided with an arc-shaped sliding groove, and the other of the first arc-shaped fitting structure and the second arc-shaped fitting structure comprises an arc-shaped protrusion, and in a process in which the electronic device switches between the folded state and the unfolded state, the arc-shaped protrusion is in slidable fit with the arc-shaped sliding groove.

3. The electronic device according to claim 1, wherein the extruded member is disposed on the first support, when the electronic device is in the folded state, the first arc-shaped fitting structure extrudes the extruded member; and when the electronic device is in the unfolded state, the first arc-shaped fitting structure is separated from the extruded member.

4. The electronic device according to claim 3, wherein in a rotating axial direction of the first connecting arm, two ends of the extruded member extend out of the first arc-shaped fitting structure.

5. The electronic device according to claim 3, wherein a groove is provided at a position at which the first support is opposite to the first arc-shaped fitting structure, the extruded member is disposed in the groove, and the extruded member is partly located outside the groove.

6. The electronic device according to claim 5, wherein in a direction perpendicular to both a rotating axial direction of the first connecting arm and a depth direction of the groove, the extruded member is in an interference fit with the groove.

7. The electronic device according to claim 5, wherein the groove comprises a mounting cavity and limiting cavities, the mounting cavity has a cavity opening, the mounting cavity is formed by being recessed from the cavity opening, the limiting cavities are provided on two sides of the mounting cavity that face away from each other, and each limiting cavity is in communication with the mounting cavity; and
the extruded member comprises a body and first protruding edges, the first protruding edges are connected to two sides of the body that face away from each other, a size of the extruded member is less than a size of the cavity opening in a rotating axial direction of the first connecting arm, the extruded member is mounted into the mounting cavity from the cavity opening, and the extruded member is capable of moving to the first protruding edge along the rotating axial direction of the first connecting arm and extending into the limiting cavity.

8. The electronic device according to claim 1, wherein the extruded member is disposed on the first arc-shaped fitting structure, and when the electronic device is in the folded state, the first support extrudes the extruded member; and when the electronic device is in the unfolded state, the first support is separated from the extruded member.

9. The electronic device according to claim 1, wherein the electronic device comprises a second support and a second connecting arm, the second support is configured to support the screen of the electronic device, a first end of the second connecting arm is rotatably mounted on the second support, a second end of the second connecting arm is provided with a third arc-shaped fitting structure, the third arc-shaped fitting structure is rotatably fitted with the base, and the extruded member is disposed between the second support and the second connecting arm;
when the electronic device is in the folded state, the extruded member abuts between the third arc-shaped fitting structure and the second support; and
when the electronic device is in the unfolded state, either of the second support and the third arc-shaped fitting structure is separated from the extruded member.

10. The electronic device according to claim 1, wherein the extruded member is a self-lubricating structural member.
